# EUROPEAN PATENT APPLICATION

(11) **EP 4 541 547 A1**
(43) Date of publication of application: **23.04.2025**
(21) Application number: 23842692.8
(22) Date of filing: 31.05.2023
(51) Int. Cl.: B29C 33/44, B29C 45/02, H01L 21/56

(54) **RESIN MOLDING DEVICE, AND METHOD FOR PRODUCING RESIN MOLDED ARTICLE**

(30) Priority: 20.07.2022 JP 2022115273
(71) Applicant: Towa Corporation, Kyoto-shi, Kyoto 601-8105 (JP)
(72) Inventor: YOSHIDA, Shuhei, Kyoto-shi, Kyoto 601-8105 (JP); OKUNISHI, Yoshito, Kyoto-shi, Kyoto 601-8105 (JP); OGAWA, Fuyuhiko, Kyoto-shi, Kyoto 601-8105 (JP)
(74) Representative: Müller Hoffmann & Partner
(86) International application number: PCT/JP2023/020369
(87) International publication number: WO 2024/018760

(57) **Abstract**

The present invention reliably collects an unnecessary resin on a pot block having an overhang while reliably unloading a resin molded product from a lower mold provided with the pot block, wherein a conveying mechanism 19 includes a first holder 20 that holds a resin molded product W2, a second holder 21 that holds an unnecessary resin K on the pot block 141, a first lifting movement mechanism 22 that lifts the first holder 20 such that the resin molded product W2 held by the first holder 20 moves upward under an overhang 141b, and a horizontal movement mechanism 23 that moves the first holder 20 in a horizontal direction such that the resin molded product W2 held by the first holder 20 moves outward with respect to the overhang 141b in a state where the first holder 20 is lifted by the first lifting movement mechanism 22, and a lower mold 15 is lowered by a clamping mechanism 17, and a plunger 142a is lifted by a transfer mechanism 142, with respect to the lower mold in a state where the resin molded product W2 is moved outward with respect to the overhang 141b, and the second holder 21 is in contact with the unnecessary resin K on the pot block 141.

## Description

### Technical Field

The present invention relates to a resin molding apparatus and a resin molded product manufacturing method.

### Background Art

There is an apparatus that has conventionally been considered, in which resin sealing is performed by clamping an upper mold and a lower mold, and injecting a molten resin into a cavity of the upper mold from a space formed between an upper surface of a pot block provided in the lower mold and a lower surface of the upper mold in a state where a part of an object to be molded is sandwiched between an overhang of the pot block and an upper surface of the lower mold, as disclosed in Patent Literature 1, for example.

In this resin molding apparatus, a resin molded product and an unnecessary resin are unloaded using a conveying apparatus (unloader) having a molded product suction part and an unnecessary resin suction part after resin molding. Here, each of the molded product suction part and the unnecessary resin suction part is formed of a suction pad made of resin.

Then, the molded product suction part sucks the resin molded product, and the molded product suction part sucking the resin molded product moves horizontally in a direction away from the pot block to move the resin molded product out of the overhang. In addition, in a state where the unnecessary resin suction part is in contact with the unnecessary resin on the pot block, the plunger is lifted to lift the unnecessary resin from the pot block, which causes the unnecessary resin suction part to suck the unnecessary resin. The suction pad of the unnecessary resin suction part elastically deforms and contracts while being in contact with the unnecessary resin when the unnecessary resin is lifted.

### Citation List

### Patent Literature

Patent Literature 1: JP 2022-39709 A

### Summary of Invention

### Technical Problem

However, for example, in a case of a resin molded product formed by using a lower mold with a cavity, with which a resin sealing part is formed on the lower side of an object to be molded , the resin molded product cannot move horizontally unless the resin sealing part on the lower side is taken out upward from the cavity of the lower mold. When the lower mold has an alignment pin for the substrate (object to be molded ), the resin molded product (substrate) cannot move horizontally unless the resin molded product is moved upward and taken out from the alignment pin. Further, for example, a release film may be provided in the lower mold even in a configuration in which the lower mold has no cavity, and it is not possible to reliably separate the resin molded product and the release film only by sucking the resin molded product with the molded product suction part.

From these problems, it is conceivable to move upward the molded product suction part sucking the resin molded product and then move the molded product suction part in a direction away from the pot block. Here, to prevent the resin molded product from hitting the overhang when the molded product suction part moves upward, it is conceivable to increase the distance between the overhang of the pot block and the mold surface of the lower mold.

However, when the distance between the overhang of the pot block and the mold surface of the lower mold is increased, the distance between the upper surface of the pot block and the lower surface of the upper mold becomes relatively small. As a result, the size of the suction pad of the unnecessary resin suction part is restricted, and the elastic deformation amount of the unnecessary resin suction part for taking out the unnecessary resin from the pot cannot be secured, which makes it difficult to stably collect the unnecessary resin.

The present invention has been made to solve the above problems. A main object of the present invention is to reliably collect an unnecessary resin on a pot block having an overhang while reliably unloading a resin molded product from a lower mold provided with the pot block. Solution to Problem

That is, a resin molding apparatus according to the present invention includes a mold including an upper mold and a lower mold and having a cavity formed in at least one of the upper mold and the lower mold, a clamping mechanism that clamps the upper mold and the lower mold, a pot block provided in the lower mold and formed with a pot that houses a resin material, a transfer mechanism that moves a plunger in the pot and injects the resin material into the cavity, and a conveying mechanism that unloads a resin molded product after resin molding from the lower mold, wherein the pot block includes an overhang overhanging between at least a part of the resin molded product and the upper mold, the conveying mechanism includes a first holder that holds the resin molded product, a second holder that holds an unnecessary resin on the pot block, a first lifting movement mechanism that lifts the first holder such that the resin molded product held by the first holder moves upward under the overhang, and a horizontal movement mechanism that moves the first holder in a horizontal direction such that the resin molded product held by the first holder moves outward with respect to the overhang in a state where the first holder is lifted by the first lifting movement mechanism, and the lower mold is lowered by the clamping mechanism and the plunger is lifted with respect to the lower mold by the transfer mechanism, in a state where the resin molded product is moved outward with respect to the overhang and the second holder is in contact with the unnecessary resin on the pot block. Advantageous Effects of Invention

The present invention configured as described above can reliably collect the unnecessary resin on the pot block having the overhang while reliably unloading the resin molded product from the lower mold provided with the pot block.

### Brief Description of Drawings

FIG. 1 is a schematic view illustrating a configuration of a resin molding apparatus according to an embodiment of the present invention.
FIG. 2 includes schematic views illustrating a state before clamping (a), a state during clamping (b), and a state after mold opening (c) in a molding module of the embodiment.
FIG. 3 is a side view schematically illustrating a configuration of a conveying mechanism of the embodiment.
FIG. 4 is a side view schematically illustrating a lifting operation (first vertical movement) of a first lifting mechanism of the embodiment.
FIG. 5 is a view schematically illustrating a configuration of a horizontal movement mechanism of the embodiment.
FIG. 6 is a view schematically illustrating an operation of the horizontal movement mechanism of the embodiment.
FIG. 7 is a side view schematically illustrating a horizontal operation of the horizontal movement mechanism of the embodiment.
FIG. 8 is a side view schematically illustrating a lifting operation (second vertical movement) of a second lifting mechanism of the same embodiment.
FIG. 9 is a side view schematically illustrating a state in which the interval between conveying claws is reduced in a conveying apparatus of the embodiment.
FIG. 10 is a side view schematically illustrating a suction operation for an unnecessary resin of the embodiment.

### Description of Embodiments

Next, the technology according to the present invention will be described in more detail with reference to examples. However, the present invention is not limited by the following technology.

That is, a resin molding apparatus of technology 1 according to the present invention includes a mold including an upper mold and a lower mold and having a cavity formed in at least one of the upper mold and the lower mold, a clamping mechanism that clamps the upper mold and the lower mold, a pot block provided in the lower mold and formed with a pot that houses a resin material, a transfer mechanism that moves a plunger in the pot and injects the resin material into the cavity, and a conveying mechanism that unloads a resin molded product after resin molding from the lower mold, wherein the pot block includes an overhang overhanging between at least a part of the resin molded product and the upper mold, the conveying mechanism includes a first holder that holds the resin molded product, a second holder that holds an unnecessary resin on the pot block, a first lifting movement mechanism that lifts the first holder such that the resin molded product held by the first holder moves upward under the overhang, and a horizontal movement mechanism that moves the first holder in a horizontal direction such that the resin molded product held by the first holder moves outward with respect to the overhang in a state where the first holder is lifted by the first lifting movement mechanism, and the lower mold is lowered by the clamping mechanism and the plunger is lifted with respect to the lower mold by the transfer mechanism, in a state where the resin molded product is moved outward with respect to the overhang and the second holder is in contact with the unnecessary resin on the pot block.

The resin molding apparatus of the present embodiment, in which the resin molded product held by the first holder moves upward under the overhang, and thereafter, the resin molded product moves outward with respect to the overhang, can reliably unload the resin molded product from the lower mold even when, for example, the resin molded product is formed with a resin sealing part formed on the lower side of the object to be molded or when a release film is provided on the lower mold.

In addition, the lower mold is lowered, and at the same time, the plunger is lifted with respect to the lower mold in a state where the resin molded product is moved outward with respect to the overhang, and the second holder is in contact with the unnecessary resin on the pot block. Thus, the unnecessary resin is peeled off from the pot block in a state where the second holder is in contact with the unnecessary resin on the pot block. As a result, it is possible to prevent collection failure caused by inclination of the unnecessary resin on the pot block.

In the resin molding apparatus of technology 2 according to the present invention, in addition to the configuration of technology 1 described above, the second holder includes a bellows type suction pad for sucking the unnecessary resin.

This configuration allows the effect of the configuration of technology 1 described above (the configuration in which the lower mold is lowered and the plunger is lifted with respect to the lower mold) to be further remarkable. That is, it is not necessary to use a suction pad having a large amount of elastic deformation, and the remaining amount (pot remaining portion) of the resin remaining in the pot is not restricted by the amount of elastic deformation of the suction pad.

The "remaining amount of the resin remaining in the pot (pot remaining portion)" deals with a variation in the resin amount or a change in the resin amount due to the presence or absence of an electronic component. For example, when the resin molding is performed using the same amount of resin material in dummy molding without an electronic component and mounting molding with an electronic component, the change in the resin material due to the presence or absence of the electronic component is absorbed by the pot remaining portion.

In a resin molding apparatus of technology 3 according to the present invention, in addition to the configuration of technology 1 or 2 described above, a height position of the plunger with respect to the second holder is maintained by the transfer mechanism lifting the plunger with respect to the lower mold.

This configuration causes the relative positional relationship between the second holder in contact with the unnecessary resin and the plunger not to change. For example, in a case where the second holder has a suction pad, the amount of elastic deformation of the suction pad hardly changes when the unnecessary resin is pushed out of the pot. Thus, it is not necessary to use a suction pad having a large amount of elastic deformation. **In** addition, since the position of the unnecessary resin hardly changes when the unnecessary resin is pushed out of the pot, the unnecessary resin can be reliably held by the second holder, and the unnecessary resin on the pot block can be reliably collected.

In a resin molding apparatus of technology 4 according to the present invention, in addition to the configuration of any one of technologies 1 to 3 described above, the conveying mechanism further includes a base member in which the first holder is movably provided, a first movable body that moves in a horizontal direction with respect to the base member, a second movable body that moves in a horizontal direction together with the first movable body and moves in an up-down direction with respect to the first movable body, and a coupling member that couples the second movable body and the first holder.

With such a configuration, when the first movable body moves in the horizontal direction with respect to the base member, the second movable body moves in the horizontal direction together with the first movable body, and the first holder coupled to the second movable body moves in the horizontal direction. When the second movable body moves in the up-down direction with respect to the first movable body, the first holder coupled to the second movable body moves in the up-down direction.

As a specific embodiment of the first lifting movement mechanism, the following is conceivable.

That is, in a resin molding apparatus of technology 5 according to the present invention, in addition to the configuration of technology 4 described above, the first lifting movement mechanism includes a first slide member that moves in a horizontal direction with respect to the base member, and a first lifting cam mechanism that moves the first holder upward by moving the second movable body upward along with the movement of the first slide member.

As a specific embodiment of the horizontal movement mechanism, the following is conceivable.

That is, in a resin molding apparatus of technology 6 according to the present invention, in addition to the configuration of technology 4 or 5 described above, the horizontal movement mechanism includes a second slide member that moves in a horizontal direction with respect to the base member, and a link mechanism that moves the first movable body in a direction away from the pot block along with the movement of the second slide member.

With this configuration, the horizontal movement mechanism includes the link mechanism, and thus the movement of the second slide member can be transmitted to the movement of the holder without difficulty.

As a specific embodiment of the conveying mechanism, the following is conceivable.

That is, in a resin molding apparatus of technology 7 according to the present invention, in addition to the configuration of any one of technologies 1 to 6 described above, the conveying mechanism further includes a second lifting movement mechanism that lifts the first holder in a state where the resin molded product is moved outward with respect to the overhang by the horizontal movement mechanism.

In a resin molding apparatus of technology 8 according to the present invention, in addition to the configuration of technology 7 described above, the conveying mechanism further includes a second lifting movement mechanism that lifts the first holder in a state where the resin molded product is moved outward with respect to the overhang by the horizontal movement mechanism, and the second lifting movement mechanism includes a second lifting cam mechanism that moves the first holder upward by moving the second movable body upward along with the horizontal movement of the second slide member.

With this configuration, the second lifting movement mechanism can be configured using the second slide member of the horizontal movement mechanism, and thus, not only the configuration can be simplified but also the cost can be reduced.

In a resin molding apparatus of technology 9 according to the present invention, in addition to the configuration of technology 7 or 8 described above, the conveying mechanism further includes a conveying claw that hooks and holds the resin molded product, and the resin molded product is held by using the conveying claw in a state where the first holder is lifted by the second lifting movement mechanism.

This configuration can stably unload the resin molded product and prevent the resin molded product from falling. In addition, since the resin molded product is held by using the conveying claw in a state where the first holder is lifted by the second lifting movement mechanism, the lower surface of the resin molded product can be held. Further, it is possible to prevent the conveying claw from coming into contact with the mold surface of the lower mold and giving a scratch.

In a resin molding apparatus of technology 10 according to the present invention, in addition to the configuration of any one of technologies 1 to 9 described above, the cavity is formed in the lower mold, and the first lifting movement mechanism lifts the first holder until a resin sealing part formed by the cavity of the lower mold is positioned above a parting line of the lower mold.

A resin molded product manufacturing method using the resin molding apparatus according to any one of technologies 1 to 10 described above, the resin molded product manufacturing method including a molding step of performing resin molding on an object to be molded , and an unloading step of unloading a resin molded product on which resin molding has been performed, is also one aspect of the present invention.

### <Embodiment of the present invention>

Hereinafter, an embodiment of a resin molding apparatus according to the present invention will be described with reference to the drawings. All the drawings described below are schematically illustrated with appropriate omission or exaggeration for easy understanding. The same components are denoted by the same reference numerals, and the description thereof will be omitted as appropriate.

### <Overall configuration of resin molding apparatus>

A resin molding apparatus 100 of the present embodiment performs resin molding of an object to be molded W1 to which an electronic component Wx is fixed through transfer molding using a resin material J.

Here, the object to be molded W1 is, for example, a metal substrate, a resin substrate, a glass substrate, a ceramic substrate, a circuit substrate, a semiconductor substrate, a lead frame, a silicon wafer, a glass wafer, or the like, and the presence or absence of wiring is irrelevant. The resin material J for resin molding is, for example, a composite material containing a thermosetting resin, and the form of the resin material J is granular, powder, liquid, sheet, tablet, or the like. Examples of the electronic component Wx include an electronic element such as a semiconductor chip, a resistance element, or a capacitor element, and an electronic component in which at least one of these electronic elements is resin-sealed.

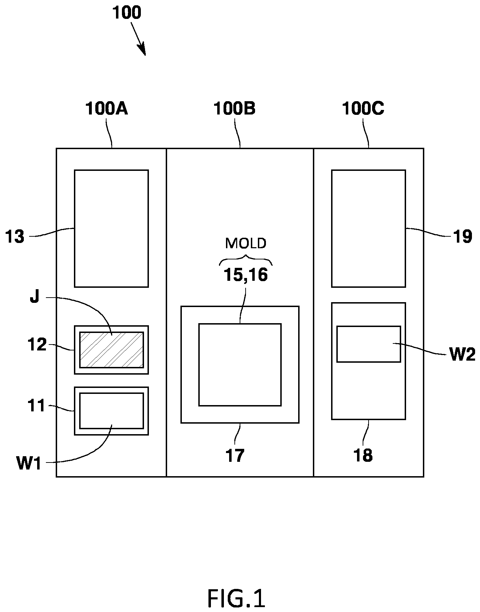

Specifically, as illustrated in FIG. 1, the resin molding apparatus 100 includes, as components, a supply module 100A that supplies the object to be molded W1 before molding and the resin material J, a molding module 100B that performs resin molding, and a storage module 100C that houses an object to be molded W2 after molding (hereinafter, resin molded product W2). The supply module 100A, the molding module 100B, and the storage module 100C can be attached to and detached from each other with respect to other components, and can be replaced with each other.

The supply module 100A includes an object to be molded supply unit 11 that supplies the object to be molded W1, a resin material supply unit 12 that supplies the resin material J, and a conveying mechanism 13 (hereinafter, loader 13) that receives the object to be molded W1 from the object to be molded supply unit 11, conveys the object to be molded W1 to the molding module 100B, receives the resin material J from the resin material supply unit 12, and conveys the object to be molded W1 to the molding module 100B.

The loader 13 moves between the supply module 100A and the molding module 100B, and it moves along a rail (not illustrated) provided across the supply module 100A and the molding module 100B.

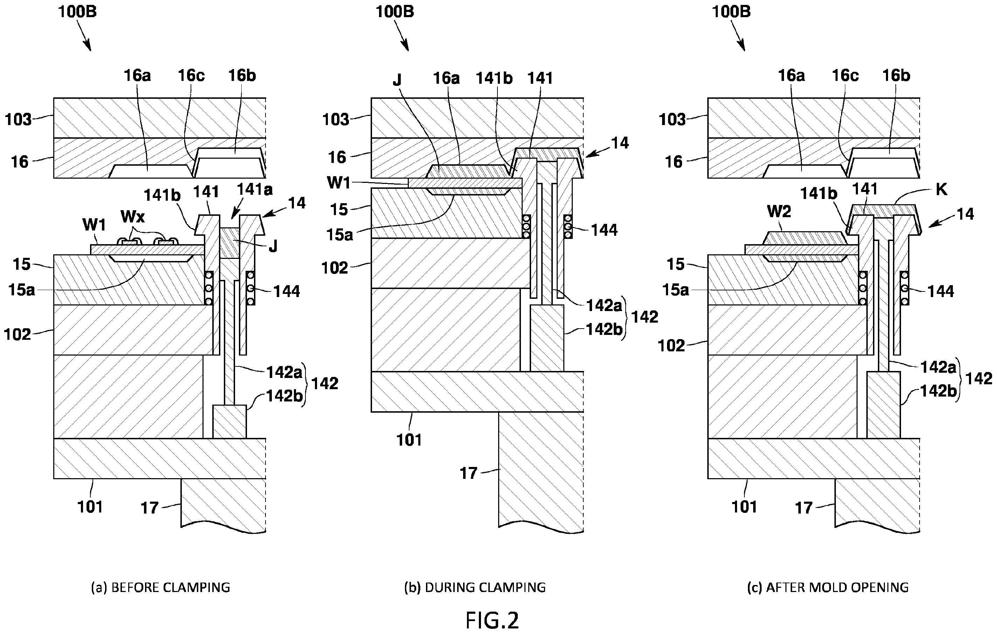

As illustrated in FIG. 2, the molding module 100B includes a lower mold 15 provided with a resin injection unit 14 and formed with a cavity 15a into which the resin material J is injected, an upper mold 16 provided to face the lower mold 15 and formed with a cavity 16a into which the resin material J is injected, and a clamping mechanism 17 that clamps the lower mold 15 and the upper mold 16. The lower mold 15 is provided on a movable platen 101 via a lower platen 102. The movable platen 101 is moved up and down by the clamping mechanism 17. The upper mold 16 is provided on an upper fixed platen (not illustrated) via an upper platen 103. FIG. 2 illustrates only one side (left side) of the resin injection unit 14, and the other side (right side) is omitted. The configuration of the other side in FIG. 2 is the same as the configuration of the one side.

The resin injection unit 14 of the present embodiment includes a pot block 141 in which a pot 141a that houses the resin material J is formed, and a transfer mechanism 142 having a plunger 142a provided in the pot 141a. Here, the transfer mechanism 142 includes the plunger 142a for pressure-feeding the resin material J housed in the pot 141a, and a plunger drive unit 142b that drives the plunger 142a. The plunger 142a pressure-feeds the resin material J heated and melted in the pot 141a.

The pot block 141 is provided in the lower mold 15, and is elastically supported by an elastic member 144 so as to be movable up and down with respect to the lower mold 15. At the upper end of the pot block 141, an overhang 141b overhanging on a mold surface which is the upper surface of the lower mold 15 is formed. In a state where the upper mold 16 and the lower mold 15 are clamped, the upper surface of the overhang 141b comes into contact with the upper mold 16, and the lower surface of the overhang 141b sandwiches the object to be molded W1 with the the mold surface of the lower mold 15 (see FIG. 2(b)). With the overhang 141b, a part where at least a part of the resin molded product W2 is overhung between the upper mold 16 and the overhang 141b (see FIG. 2 (c)) is formed after resin molding. Further, on the upper surface of the pot block 141, a cal part and a gate part (both not illustrated) serving as a resin flow path for introducing the resin material J injected from the pot 141a into the cavities 15a and 16a may be formed.

The cavity 15a of the lower mold 15 is for resin-sealing the lower surface of the object to be molded W1, and the cavity 16a of the upper mold 16 is for resin-sealing the upper surface of the object to be molded W1. Here, the electronic component Wx of the object to be molded W1 is housed in at least one of the cavity 15a of the lower mold 15 and the cavity 16a of the upper mold 16.

In the upper mold 16, a recess 16b is formed in a portion facing the overhang 141b of the pot block 141, and a runner 16c that connects the cal part and the gate part of the pot block 141 and the cavities 15a and 16a is formed. In the lower mold 15, a runner part that connects the cal part and the gate part of the pot block 141 and the cavities 15a and 16a may be formed. Although not illustrated, the lower mold 15 or the upper mold 16 is formed with an air vent on the opposite side from the pot block 141.

As illustrated in FIG. 2(b), when the lower mold 15 and the upper mold 16 are clamped by the clamping mechanism 17, the pot block 141 lowers, and the pot-side end of the object to be molded W1 is sandwiched between the lower surface of the overhang 141b of the pot block 141 and the upper surface of the lower mold 15. When the resin material J melted by the plunger 142a is injected into the cavities 15a and 16a in this state, the electronic component Wx of the object to be molded W1 is resin-sealed.

The storage module 100C is provided with a storage part 18 that stores the resin molded product W2, and a conveying mechanism 19 (hereinafter, unloader 19) that receives the resin molded product W2 from the molding module 100B and conveys the resin molded product W2 to the storage part 18.

The unloader 19 moves between the molding module 100B and the storage module 100C, and it moves along a rail (not illustrated) provided across the molding module 100B and the storage module 100C. Details of the unloader 19 will be described later.

A basic operation of the resin molding apparatus 100 will be briefly described with reference to FIG. 2. The following operation is performed, for example, by a control unit COM provided in the supply module 100A controlling each unit.

In a state where the lower mold 15 and the upper mold 16 are open, the object to be molded W1 is conveyed by the loader 13 and placed on the lower mold 15 as illustrated in FIG. 2(a). At this time, the upper mold 16 and the lower mold 15 are heated to a temperature at which the resin material J can be melted and cured. The resin material J is conveyed by the loader 13 and housed in the pot 141a of the pot block 141.

When the lower mold 15 is lifted by the clamping mechanism 17 in this state, as illustrated in FIG. 2(b), the pot block 141 comes into contact with the upper mold 16 and lowers with respect to the lower mold 15, and the lower surface of the overhang 141b comes into contact with the pot-side end of the object to be molded W1. The lower surface of the upper mold 16 comes into contact with the vent-side end of the object to be molded W1. This causes the lower mold 15 and the upper mold 16 to be clamped. When the plunger drive unit 142b lifts the plunger 142a after the clamping, the molten resin material J in the pot 141a is injected into the cavities 15a and 16a through the resin passage. Then, after the resin material J is cured in the cavities 15a and 16a, the molds are opened by the clamping mechanism 17 as illustrated in FIG. 2(c). This mold opening causes the pot block 141 to lift with respect to the lower mold 15 and the elastic member 144 of the pot block 141 to extend. When the plunger 142a lifts in accordance with the extension of the elastic member 144, an unnecessary resin K on the pot block 141 separates from the resin molded product W2 (gate break). Thereafter, the resin molded product W2 is unloaded by the unloader 19 and conveyed to the storage part 18.

### <Specific configuration of unloader 19>

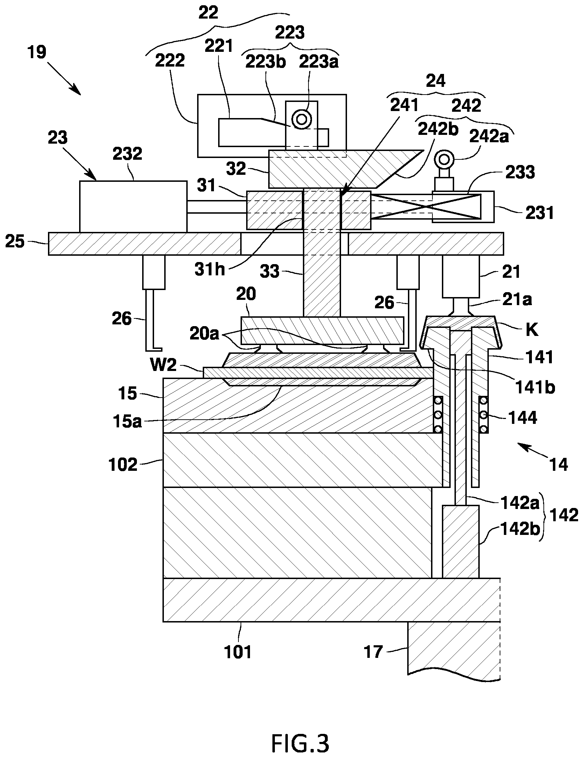

Next, a specific configuration of the unloader 19 in the present embodiment will be described with reference to FIGS. 3 to 10. FIGS. 3 and 6 to 10 illustrate only one side (left side) of the pot block 141, and the other side (right side) is omitted. The state of the other side is the same as the state of the one side in each drawing.

As illustrated in FIGS. 3 to 10, the unloader 19 includes a first holder 20 that holds the resin molded product W2, a second holder 21 that holds the unnecessary resin K on the pot block 141, a first lifting movement mechanism 22 that lifts the first holder 20 such that the resin molded product W2 held by the first holder 20 moves upward under the overhang 141b, a horizontal movement mechanism 23 that horizontally moves the first holder 20 such that the resin molded product W2 held by the first holder 20 moves outward with respect to the overhang 141b in a state where the first holder 20 is lifted by the first lifting movement mechanism 22, and a second lifting movement mechanism 24 that lifts the first holder 20 in a state where the resin molded product W2 is moved outward with respect to the overhang 141b by the horizontal movement mechanism 23.

The first holder 20 holds the resin molded product W2 from which the unnecessary resin K on the pot block 141 has been separated. The holder includes a molded product suction pad 20a that sucks the resin molded product W2 placed on the lower mold 15. The molded product suction pad 20a is provided on the lower surface of the first holder 20, and a suction mechanism (not illustrated) for sucking the resin molded product W2 is connected to the molded product suction pad 20a. The molded product suction pad 20a of the present embodiment is a bellows suction pad. The suction mechanism includes, for example, a suction flow path formed inside the first holder 20 and a suction pump connected to the suction flow path.

The second holder 21 includes an unnecessary resin suction pad 21a that sucks the unnecessary resin K on the pot block 141. The unnecessary resin suction pad 21a is provided on the lower surface of the second holder 21, and a suction mechanism (not illustrated) for sucking the unnecessary resin K is connected to the unnecessary resin suction pad 21a. The unnecessary resin suction pad 21a of the present embodiment is a bellows type suction pad. The suction mechanism includes, for example, a suction flow path formed inside the second holder 21 and a suction pump connected to the suction flow path.

The first holder 20 and the second holder 21 are provided in the base member 25. Specifically, the first holder 20 is movably provided on the base member 25, and the second holder 21 is fixed to the base member 25. The second holder 21 may be movably provided on the base member 25.

As a configuration that allows the first holder 20 to move to the base member 25, the unloader 19 includes a first movable body 31 that moves in the horizontal direction with respect to the base member 25, a second movable body 32 that moves in the horizontal direction together with the first movable body 31 and moves in an up-down direction with respect to the first movable body 31, and a coupling member 33 that couples the second movable body 32 and the first holder 20.

The first movable body 31 has, for example, a flat plate shape that moves in the horizontal direction on the base member 25. The first movable body 31 is provided to be movable in a direction toward or away from the pot block 141 with respect to the base member 25 using a guide part (not illustrated). The guide part includes a rail provided in the base member 25 in a front-back direction to move back and forth with respect to the pot block 141, and a slider provided in the first movable body 31 to move on the rail.

The second movable body 32 has, for example, a flat plate shape that moves in an up-down direction with respect to the first movable body 31. The second movable body 32 is provided with the first movable body 31 sandwiched between the first holder 20 and the second movable body 32.

The coupling member 33 coupling the second movable body 32 and the first holder 20 is provided so as to be movable up and down with respect to the first movable body 31 through a through hole 31h formed in the first movable body 31. Here, one or a plurality of coupling members 33 are provided, and when a plurality of coupling members 33 are provided, the second movable body 32 and the first holder 20 are coupled at a plurality of positions. The through hole 31h formed in the first movable body 31 and the coupling member 33 function as a guide part 241 that guides the movement of the second movable body 32 in the up-down direction.

With such a configuration, when the first movable body 31 moves in the horizontal direction with respect to the base member 25, the second movable body 32 moves in the horizontal direction together with the first movable body 31, and the first holder 20 coupled to the second movable body 32 moves in the horizontal direction. When the second movable body 32 moves in the up-down direction with respect to the first movable body 31, the first holder 20 coupled to the second movable body 32 moves in the up-down direction.

The base member 25 is provided to be movable in the horizontal direction and the up-down direction along a rail (not illustrated). The base member 25 is provided with a conveying claw 26 for preventing the resin molded product W2 held by the first holder 20 from falling or holding the resin molded product W2. A pair of conveying claws 26 is provided so as to hook both ends of the resin molded product W2, and the interval between the conveying claws 26 is increased or reduced by a drive unit (not illustrated). The distance between the conveying claws 26 is reduced by the drive unit so as to hook the resin molded product W2, and the distance between the conveying claws 26 is increased so as not to block the lifting and lowering movement of the resin molded product W2 moved by a second lifting movement mechanism 24.

### <First lifting movement mechanism 22>

The first lifting movement mechanism 22 moves the first holder 20 up and down, and linearly moves the resin molded product W2 held by the first holder 20 upward under the overhang 141b. During the movement with the first lifting movement mechanism 22, the first holder 20 is in a state of sucking and holding the resin molded product W2.

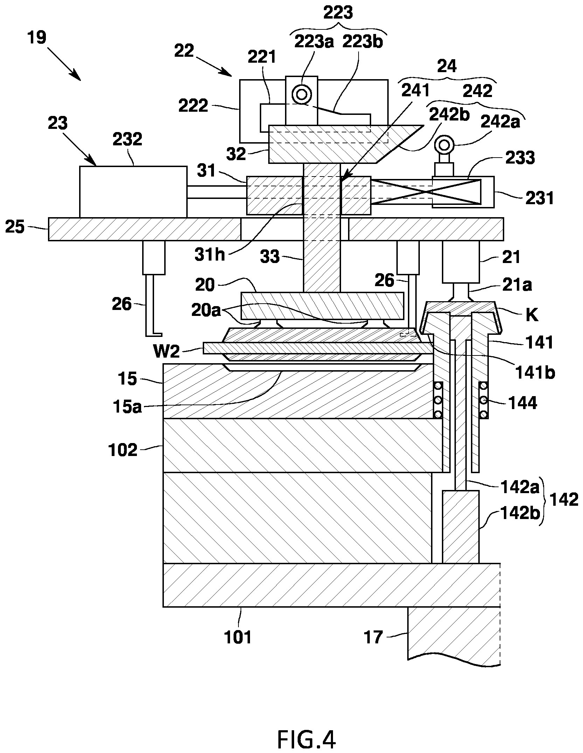

Here, the first lifting movement mechanism 22 lifts the first holder 20 until the lower resin sealing part formed by the cavity 15a of the lower mold 15 is positioned above the parting line (mold surface) of the lower mold 15 (see FIG. 4). The lifting amount of the first holder 20 lifted by the first lifting movement mechanism 22 is such that the resin molded product W2 does not come into contact with the overhang 141b of the pot block 141. The height position of the overhang 141b of the pot block 141 with respect to the lower mold 15 is set to such an extent that the resin molded product W2 lifted by the first lifting movement mechanism 22 does not come into contact with the pot block 141.

Specifically, as illustrated in FIGS. 3, 4, and 7 to 10, the first lifting movement mechanism 22 includes a first slide member 221 that moves in the horizontal direction with respect to the base member 25, a first drive unit 222 that moves the first slide member 221, and a first lifting cam mechanism 223 that moves the first holder 20 upward by moving the second movable body 32 upward along with the movement of the first slide member 221. The first slide member 221 of the present embodiment is configured to move in a direction toward or away from the pot block 141. The first drive unit 222 is, for example, a block including an air cylinder (not illustrated), and the first slide member 221 and the first drive unit 222 are configured by an air slide table.

As illustrated in FIGS. 3, 4, and 7 to 10, the first lifting cam mechanism 223 includes a lifting roller member 223a provided in the second movable body 32, and a lifting roller contact part 223b provided in the first slide member 221 to move the lifting roller member 223a along with the movement of the first slide member 221. The lifting roller contact part 223b has an inclined surface that comes into contact with the lifting roller member 223a and moves the lifting roller member 223a upward as the first slide member 221 moves in the direction toward the pot block 141. The lifting roller member 223a may be formed of, for example, a rolling element (bearing) or a bush rotatably provided on the second movable body 32.

When the first slide member 221 is moved in the direction toward the pot block 141 by such a first lifting movement mechanism 22, the lifting roller member 223a in contact with the inclined surface of the lifting roller contact part 223b moves upward (see FIG. 4). This causes the second movable body 32 and the first holder 20 coupled to the second movable body 32 to move upward with respect to the first movable body 31 (first vertical movement).

When the first slide member 221 is moved in the direction away from the pot block 141, the second movable body 32 and the first holder 20 coupled to the second movable body 32 move downward with respect to the first movable body 31 by its own weight (see FIG. 3).

### <Horizontal movement mechanism 23>

The horizontal movement mechanism 23 linearly moves the first holder 20 holding the resin molded product W2 in a direction away from the pot block 141. As described above, since the resin molded product W2 is positioned above the parting line (mold surface) of the lower mold 15 by the first lifting movement mechanism 22, the horizontal movement mechanism 23 linearly moves the resin molded product W2 sucked and held by the suction pad 20a in a direction away from the pot block 141.

Specifically, as illustrated in FIGS. 3 to 10, the horizontal movement mechanism 23 includes a second slide member 231 that moves in the horizontal direction with respect to the base member 25, a second drive unit 232 that moves the second slide member 231, and a link mechanism 233 that moves the first movable body 31 in a direction away from the pot block 141 along with the movement of the second slide member 231. The second slide member 231 of the present embodiment is configured to move in a direction toward or away from the pot block 141. The second drive unit 232 uses, for example, an air cylinder.

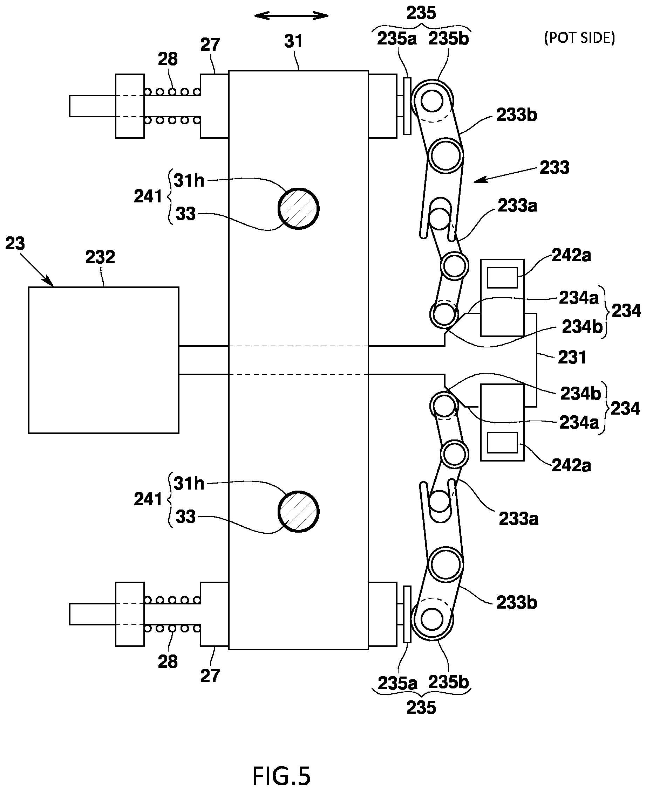

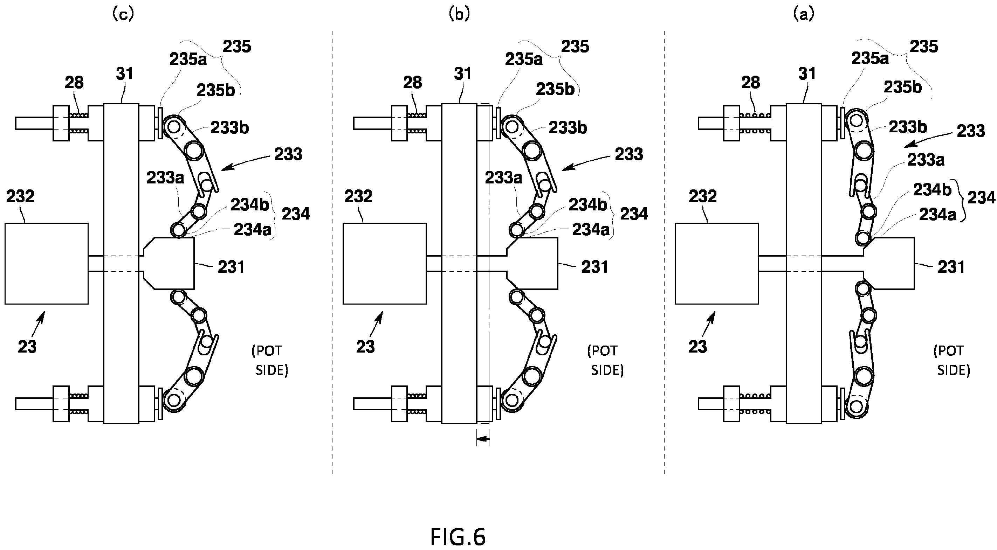

As illustrated in FIGS. 5 and 6, the link mechanism 233 of the present embodiment is configured to move the first holder 20 (first movable body 31) in a direction away from the pot block 141 as the second slide member 231 moves in a direction away from the pot block 141. Here, the link mechanism 233 includes first and second link arms 233a and 233b rotatably provided on the base member 25. The second link arm 233b is configured to rotate in a direction opposite to the first link arm 233a along with the rotation of the first link arm 233a.

Further, as illustrated in FIGS. 5 and 6, the horizontal movement mechanism 23 is provided with a first horizontal cam mechanism 234 between the second slide member 231 and the link mechanism 233, and is provided with a second horizontal cam mechanism 235 between the link mechanism 233 and the first movable body 31.

The first horizontal cam mechanism 234 includes a first roller contact part 234a provided on the second slide member 231 and a first roller member 234b provided on the first link arm 233a and moving along the first roller contact part 234a. The first roller contact part 234a of the present embodiment includes an inclined surface and a flat surface formed on a side surface of the second slide member 231, and is configured such that the first roller member 234b slides on the inclined surface and the flat surface. As the first roller member 234b moves along the inclined surface of the first roller contact part 234a, the first link arm 233a rotates in one direction (see FIG. 6(b)). On the other hand, when the first roller member 234b moves along

the flat surface of the first roller contact part 234a, the first link arm 233a maintains its state without rotating (see FIG. 6(c)). The first roller member 234b may be formed of, for example, a rolling element (bearing) or a bush rotatably provided at the inner end of the first link arm 233a.

The second horizontal cam mechanism 235 includes a second roller contact part 235a provided on the first movable body 31 and a second roller member 235b provided on the second link arm 233b and moving along the second roller contact part 235a. The second roller member 235b may be formed of, for example, a rolling element (bearing) or a bush rotatably provided at the outer end of the second link arm 233b. The second roller contact part 235a is provided on the surface of the first movable body 31 facing the pot block 141, and is a flat surface in the present embodiment.

With such a link mechanism 233, when the second slide member 231 moves in the direction away from the pot block 141 (FIG. 6(a) → (b)), the first roller member 234b moves along the inclined surface of the first roller contact part 234a of the second slide member 231, and the first link arm 233a rotates. Then, along with the rotation of the first link arm 233a, the second link arm 233b rotates in the direction opposite to the first link arm 232a, and the second roller member 235b of the second link arm 233b pushes the second roller contact part 235a of the first movable body 31 in the direction away from the pot block 141. This causes the first movable body 31 to move in the direction away from the pot block 141. Thereafter, when the first roller member 234b reaches the flat surface of the first roller contact part 234a (FIG. 6(b) → (c)), the rotation of the first link arm 233a stops, and the movement of the first movable body 31 in the horizontal direction stops.

The first movable body 31 is biased toward the pot block 141 by, for example, an elastic member 28 provided via a T-shaped block 27, and when the second slide member 231 moves toward the pot block 141, the first movable body 31 moves toward the pot block 141.

### <Second lifting movement mechanism 24>

The second lifting movement mechanism 24 lifts the first holder 20 in a state where the resin molded product W2 has been moved outward with respect to the overhang 141b by the horizontal movement mechanism 23. The second lifting movement mechanism 24 linearly moves the second movable body 32 moved by the horizontal movement mechanism 23 upward to move the first holder 20 coupled to the second movable body 32 upward.

Specifically, as illustrated in FIGS. 3, 4, and 7 to 10, the second lifting movement mechanism 24 includes a guide part 241 that guides the second movable body 32 in the vertical direction (up-down direction), and a second lifting cam mechanism 242 that moves the second movable body 32 upward along with the horizontal movement of the second slide member 231 of the horizontal movement mechanism 23.

The guide part 241 of the present embodiment is formed of a through hole 31h of the first movable body 31 and a coupling member 33 by inserting the coupling member 33 into the through hole 31h. The guide part 241 may include a rail provided in the first movable body 31 in the up-down direction and a slider provided in the second movable body to move on the rail.

As illustrated in FIGS. 3, 4, and 7 to 10, the second lifting cam mechanism 242 includes a lifting roller member 242a provided on the second slide member 231, and a lifting roller contact part 242b provided on the second movable body 32 and moving along with the movement of the lifting roller member 242a. The lifting roller contact part 242b has an inclined surface provided such that the lifting roller contact part 242b moves upward as the lifting roller member 242a moves in the direction away from the pot block 141.

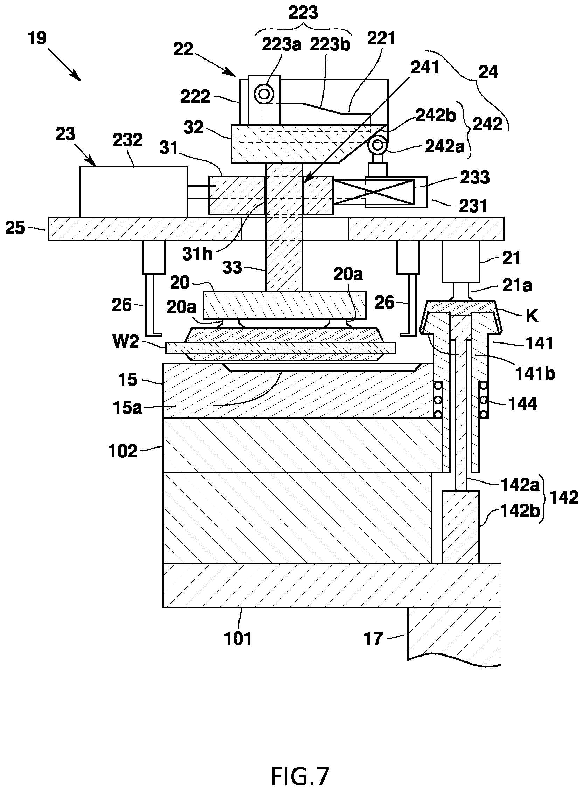

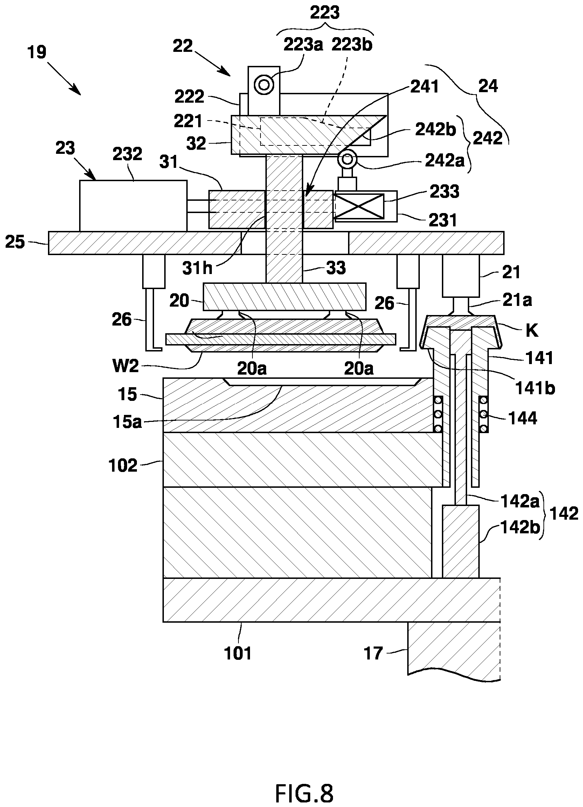

When the second slide member 231 moves in the direction away from the pot block 141 because of such a second lifting movement mechanism 24 (FIG. 6(b) → (c)), the lifting roller member 242a comes into contact with the inclined surface of the lifting roller contact part 242b (see FIG. 7), and the lifting roller contact part 242b moves upward (see FIG. 8). This causes the second movable body 32 and the first holder 20 coupled to the second movable body 32 to move upward with respect to the first movable body 31 (second vertical movement).

When the second slide member 231 moves toward the pot block 141, the second movable body 32 and the first holder 20 coupled to the second movable body 32 move downward with respect to the first movable body 31 by its own weight (see FIG. 7).

### <Unloading operation of unloader 19>

Next, the unloading operation of the unloader 19 will be described with reference to FIGS. 3 to 10.

In a state where the upper mold 16 and the lower mold 15 are open, as illustrated in FIG. 3, the unloader 19 is moved above the lower mold 15, and then lowered to a predetermined position for sucking and holding the resin molded product W2 and the unnecessary resin K. Then, the resin molded product W2 is sucked and held by the suction pad 20a of the first holder 20, and the unnecessary resin K is sucked and held by the suction pad 21a of the second holder 21. The distance between the conveying claws 26 is increased so as not to block the suction and holding of the resin molded product W2. The second holder 21 provided on the base member 25 comes into contact with the unnecessary resin K remaining on the upper surface of the pot block 141.

Then, as illustrated in FIG. 4, when the first slide member 221 of the first lifting movement mechanism 22 is moved, the second movable body 32 is lifted along with the movement. Specifically, when the first slide member 221 is moved in the direction toward the pot block 141, the second movable body 32 is moved upward by the first lifting cam mechanism 223. When the second movable body 32 moves upward, the first holder 20 coupled to the second movable body 32 moves upward (first vertical movement). This first vertical movement causes the lower resin sealing part of the resin molded product W2 held by the first holder 20 to be positioned above the parting line (mold surface) of the lower mold 15. When a release film is provided in the lower mold 15, the lower resin sealing part is positioned above the upper surface of the release film on the parting line.

Next, as illustrated in FIG. 7, the first movable body 31 is moved in a direction away from the pot block 141 by the horizontal movement mechanism 23. Specifically, when the second slide member 231 of the horizontal movement mechanism 23 is moved in the direction away from the pot block 141, the first movable body 31 is moved in the direction away from the pot block 141 by the link mechanism 233 and the horizontal cam mechanisms 234 and 235 (FIG. 6(a) → (b)). When the first movable body 31 moves, the second movable body 32 and the first holder 20 also move simultaneously together with the first movable body 31. This movement causes the resin molded product W2 to move outward with respect to the overhang 141b of the pot block 141.

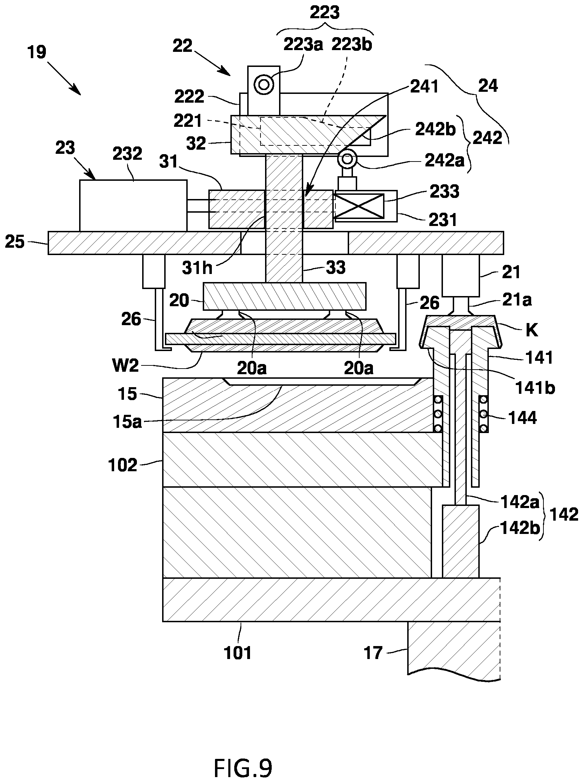

Further, as illustrated in FIG. 8, when the second slide member 231 of the horizontal movement mechanism 23 is moved, the second movable body 32 is lifted along with the movement. Specifically, when the second slide member 231 is moved in the direction away from the pot block 141 from the state of FIG. 7 (FIG. 6(b) → (c)), the second movable body 32 is moved upward by the second lifting cam mechanism 242. When the second movable body 32 moves upward, the first holder 20 coupled to the second movable body 32 also moves upward at the same time (second vertical movement). This second vertical movement causes the resin molded product W2 to move to such a height that the resin molded product W2 can be held by the conveying claws 26. Then, as illustrated in FIG. 9, the interval between the conveying claws 26 is reduced so that the conveying claws 26 are positioned below the resin molded product W2. When the second vertical movement ends, the movement of the second slide member 231 ends.

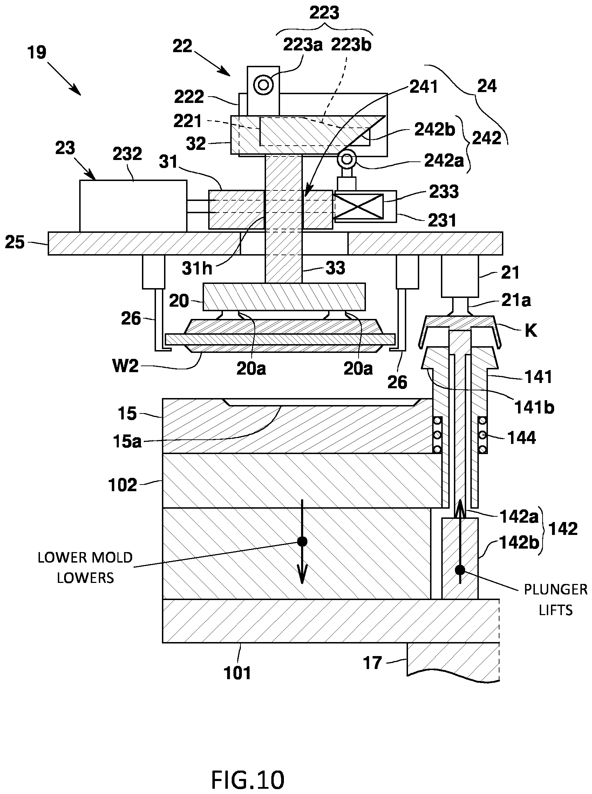

As described above, after the resin molded product W2 is moved outward with respect to the overhang 141b and the second holder 21 is brought into contact with the unnecessary resin K on the pot block 141, the lower mold 15 is lowered by the clamping mechanism 17, and the plunger 142a is lifted with respect to the lower mold 15 by the transfer mechanism 142 as illustrated in FIG. 10. When the lower mold 15 is lowered, the pot block 141 is also lowered.

In the present embodiment, the plunger 142a is lifted with respect to the lower mold 15 by the transfer mechanism 142, which maintains the height position of the plunger 142a with respect to the second holder 21 regardless of the lowering of the lower mold 15. This causes the relative positional relationship between the second holder 21 sucking and holding the unnecessary resin K and the plunger 142a not to change. In other words, when the unnecessary resin K is pushed out of the pot 141a, the amount of elastic deformation of the suction pad 21a of the second holder 21 hardly changes. Then, by the above operation, the unnecessary resin K sucked and held by the suction pad 21a of the second holder 21 is peeled off from the pot block 141 and lifted.

In this manner, when the first holder 20 sucks and holds the resin molded product W2 and second holder 21 sucks and holds the unnecessary resin K, the unloader 19 exits from the upper mold 16 and the lower mold 15, conveys the resin molded product W2 to the storage part 18 of the storage module 100C, and conveys the unnecessary resin K to a disposal box (not illustrated).

<Effects of present embodiment>

The resin molding apparatus 100 of the present embodiment, in which the resin molded product W2 held by the first holder 20 moves upward under the overhang 141b, and thereafter, the resin molded product W2 moves outward with respect to the overhang 141b, can reliably unload the resin molded product W2 from the lower mold 15 even when, for example, the resin molded product W2 is formed with a resin sealing part formed on the lower side of the object to be molded W1 or when a release film is provided on the lower mold 15.

In addition, the lower mold 15 is lowered by the clamping mechanism 17, and at the same time, the plunger 142a is lifted with respect to the lower mold 15 by the transfer mechanism 142 in a state where the resin molded product W2 is moved outward with respect to the overhang 141b, and the second holder 21 is in contact with the unnecessary resin K on the pot block 141. Thus, the unnecessary resin K is peeled off from the pot block 141 in a state where the second holder 21 is in contact with the unnecessary resin K on the pot block 141. As a result, it is possible to prevent collection failure caused by inclination of the unnecessary resin K on the pot block 141.

### <Other modified embodiments>

The present invention is not limited to the above embodiment.

For example, in the above embodiment, the second lifting movement mechanism 24 is configured using the second slide member 231 of the horizontal movement mechanism 23, but the second lifting movement mechanism 24 may be provided separately from the horizontal movement mechanism 23 without using the second slide member 231.

In the above embodiment, the lower mold 15 has the cavity 15a, but the lower mold 15 may have no cavity 15a. In this case as well, the resin molded product W2 can be reliably unloaded from the lower mold 15 in the configuration in which a release film is provided in the lower mold 15.

In the above embodiment, when the lower mold 15 is lowered to push out the unnecessary resin K from the pot 141a, the height position of the plunger 142a with respect to the second holder 21 is maintained, but it is not always necessary to maintain the height position of the plunger 142a. For example, the height position of the plunger 142a with respect to the second holder 21 may be changed in a range in which the suction pad 21a of the second holder 21 is maintained in contact with the unnecessary resin K.

In the first lifting cam mechanism 223 of the first lifting movement mechanism 22 of the embodiment, the lifting roller member 223a may be provided in the first slide member 221, and the lifting roller contact part 223b may be provided in the second movable body 32. In the second lifting cam mechanism 242 of the second lifting movement mechanism 24, the lifting roller member 242a may be provided in the second movable body 32, and the lifting roller contact part 242b may be provided in the second slide member 231.

Further, in the above embodiment, the first holder 20 is configured to move in the direction away from the pot block 141 by moving the second slide member 231 in the direction away from the pot block 141, but the first holder 20 may be configured to move in the direction away from the pot block 141 by moving the second slide member 231 in the direction toward the pot block 141. In this case, for example, it is conceivable that the link mechanism 233 is formed of one link arm (for example, the first link arm 233a of the above embodiment).

In the above embodiment, when the unloader 19 is lowered to the predetermined position for sucking and holding the resin molded product W2, the second holder 21 comes into contact with the unnecessary resin K on the pot block 141. However, the second holder 21 may be brought into contact with the unnecessary resin K on the pot block 141 after the resin molded product W2 is lifted by the second lifting movement mechanism 24.

**In** the above embodiment, the conveying claw 26 prevents the resin molded product W2 sucked and held from falling. However, the suction and holding may be released after the resin molded product W2 is lifted, and the resin molded product W2 may be held by the conveying claw 26. The conveying claw 26 does not have to be provided as long as the suction and holding is performed at the time of conveyance.

The present invention is not limited to the above embodiments, and it is needless to say that various modifications can be made without departing from the gist of the present invention.

### Industrial Applicability

The present invention can reliably collect the unnecessary resin on the pot block having the overhang while reliably unloading the resin molded product from the lower mold provided with the pot block.

### Reference Signs List

- 100: resin molding apparatus
- J: resin material
- W1: object to be molded
- W2: resin molded product
- K: unnecessary resin
- 141: pot block
- 141a: pot
- 141b: overhang
- 142: transfer mechanism
- 142a: plunger
- 15: lower mold
- 15a: cavity
- 16: upper mold
- 16a: cavity
- 17: clamping mechanism
- 19: conveying mechanism (unloader)
- 20: first holder
- 20a: molded product suction pad
- 21: second holder
- 21a: unnecessary resin suction pad
- 22: first lifting movement mechanism
- 221: first slide member
- 223: first lifting cam mechanism
- 23: horizontal movement mechanism
- 231: second slide member
- 233: link mechanism
- 24: second lifting movement mechanism
- 242: second lifting cam mechanism
- 25: base member
- 26: conveying claw
- 31: first movable body
- 32: second movable body
- 33: coupling member

## Claims

1. A resin molding apparatus comprising:
a mold including an upper mold and a lower mold and having a cavity formed in at least one of the upper mold and the lower mold;
a clamping mechanism that clamps the upper mold and the lower mold;
a pot block provided in the lower mold and formed with a pot that houses a resin material;
a transfer mechanism that moves a plunger in the pot and injects the resin material into the cavity; and
a conveying mechanism that unloads a resin molded product after resin molding from the lower mold,
wherein
the pot block includes an overhang overhanging between at least a part of the resin molded product and the upper mold,
the conveying mechanism includes:
a first holder that holds the resin molded product;
a second holder that holds an unnecessary resin on the pot block;
a first lifting movement mechanism that lifts the first holder such that the resin molded product held by the first holder moves upward under the overhang; and
a horizontal movement mechanism that moves the first holder in a horizontal direction such that the resin molded product held by the first holder moves outward with respect to the overhang in a state where the first holder is lifted by the first lifting movement mechanism, and
the lower mold is lowered by the clamping mechanism and the plunger is lifted with respect to the lower mold by the transfer mechanism, in a state where the resin molded product is moved outward with respect to the overhang and the second holder is in contact with the unnecessary resin on the pot block.

2. The resin molding apparatus according to claim 1, wherein a height position of the plunger with respect to the second holder is maintained by the transfer mechanism lifting the plunger with respect to the lower mold.

3. The resin molding apparatus according to claim 1 or 2, wherein the conveying mechanism further including:
a base member in which the first holder is movably provided;
a first movable body that moves in a horizontal direction with respect to the base member;
a second movable body that moves in a horizontal direction together with the first movable body and moves in an up-down direction with respect to the first movable body; and
a coupling member that couples the second movable body and the first holder.

4. The resin molding apparatus according to claim 3, wherein
the first lifting movement mechanism includes:
a first slide member that moves in a horizontal direction with respect to the base member; and
a first lifting cam mechanism that moves the first holder upward by moving the second movable body upward along with the movement of the first slide member.

5. The resin molding apparatus according to claim 3 or 4, wherein
the horizontal movement mechanism includes:
a second slide member that moves in a horizontal direction with respect to the base member; and
a link mechanism that moves the first movable body in a direction away from the pot block along with the movement of the second slide member.

6. The resin molding apparatus according to any one of claims 1 to 5, wherein the conveying mechanism further includes a second lifting movement mechanism that lifts the first holder in a state where the resin molded product is moved outward with respect to the overhang by the horizontal movement mechanism.

7. The resin molding apparatus according to claim 5, wherein
the conveying mechanism further includes a second lifting movement mechanism that lifts the first holder in a state where the resin molded product is moved outward with respect to the overhang by the horizontal movement mechanism, and
the second lifting movement mechanism includes a second lifting cam mechanism that moves the first holder upward by moving the second movable body upward along with the horizontal movement of the second slide member.

8. The resin molding apparatus according to claim 6 or 7, wherein
the conveying mechanism further includes a conveying claw that hooks and holds the resin molded product, and
the resin molded product is held by using the conveying claw in a state where the first holder is lifted by the second lifting movement mechanism.

9. The resin molding apparatus according to any one of claims 1 to 8, wherein
the cavity is formed in the lower mold, and
the first lifting movement mechanism lifts the first holder until a resin sealing part formed by the cavity of the lower mold is positioned above a parting line of the lower mold.

10. A resin molded product manufacturing method using the resin molding apparatus according to any one of claims 1 to 9, the resin molded product manufacturing method comprising:
a molding step of performing resin molding on an object to be molded; and
an unloading step of unloading a resin molded product on which resin molding has been performed.
